# DEMANDE DE BREVET EUROPEEN

(11) **EP 4 398 288 A1**
(43) Date de publication de la demande: **10.07.2024**
(21) Numéro de dépôt: 23216159.6
(22) Date de dépôt: 13.12.2023
(51) Int. Cl.: H01L 21/308, H01L 21/02, H01L 21/266, H01L 23/31

(54) **PROCÉDÉ DE TRANSFORMATION D'UN SUPPORT**

(30) Priorité: 19.12.2022 FR 2213748
(71) Demandeur: Commissariat à l'énergie atomique et aux énergies alternatives, 75015 Paris (FR)
(72) Inventeur: LAURENT, Romain, 38054 Grenoble cedex 09 (FR); MEHREZ, Zouhir, 38054 Grenoble cedex 09 (FR)
(74) Mandataire: Hautier IP

(57) **Abrégé**

L'invention concerne un procédé de transformation d'un support comprenant les étapes suivantes :
- fournir un support (10) présentant une face supérieure (11),
- réaliser un revêtement de protection (100) surmontant au moins partiellement une zone périphérique (14) de la face supérieure formant un contour fermé autour d'une zone centrale (15) de la face supérieure.

Le procédé se caractérise en ce que la réalisation du revêtement de protection comprend les étapes suivantes :
- former une première couche (20) d'une résine photosensible inversible surmontant la face supérieure du support,
- exposer une première portion (24) de la première couche de résine photosensible avec une première dose d'insolation supérieure à la dose d'inversion de la résine, la première portion couvrant strictement la même surface de la face supérieure que le revêtement de protection, de sorte à former le revêtement de protection.

## Description

### DOMAINE TECHNIQUE

La présente invention concerne le domaine de la microélectronique. Elle trouve pour application particulièrement avantageuse tous les procédés de fabrication dans lesquels la périphérie de la plaquette, ou « wafer », doit être protégée. De telles plaquettes correspondent aux supports ou substrats, généralement à base de matériaux semiconducteurs comme le silicium, sur lesquels les composants microélectroniques, telles des puces, sont fabriqués ; la singularisation des composants est opérée par découpe de la plaquette.

### ETAT DE LA TECHNIQUE

Lors de la fabrication de dispositifs microélectroniques sur une plaquette - plus couramment désignée par le terme anglais de « wafer » -, il est important de protéger la périphérie de cette dernière, c'est-à-dire la zone située au niveau de la tranche de la plaquette. Cette zone de tranche, couramment désignée « bevel », est en effet exposée à un grand nombre d'étapes de fabrication pouvant endommager son état de surface ou la contaminer. Une protection du wafer allant au-delà de sa périphérie peut par ailleurs être recherchée. Cela est notamment le cas pour des applications où des substrats de petites dimensions sont disposés sur un substrat de grande dimension afin de pouvoir être manipulés et transformés avec des machines et procédés conventionnels. Dans une telle situation, on peut vouloir protéger toute la zone située en dehors des substrats de petites dimensions pour éviter que celle-ci n'ait d'impact lors des procédés.

Aujourd'hui, une technique existante pour protéger le bevel est une technique de dépôt de matériau, le plus souvent un oxyde (ex. : SiO₂) ou un nitrure (ex. : SiN), à la périphérie du wafer et encapsulant le bevel. Cette technique est développée sur certains équipements de dépôt par phase plasma.

Cependant, cette solution présente de nombreux désavantages. Tout d'abord, le fait de déposer de la matière (SiOz ou SiN) sur le bevel suppose un transfert de matière non négligeable et donc une possible dégradation de l'état de surface du bevel, ce qui va dans le sens inverse à l'effet recherché. Des réactions à l'interface entre le substrat et la couche déposée peuvent également survenir, ce qui a pour conséquence de dégrader davantage encore l'état de surface du bevel.

Un autre défaut de cette solution réside dans le fait qu'elle doit être mise en oeuvre lors d'une étape totalement indépendante du reste du procédé et ne peut être réalisée en ligne. Par ailleurs, la couche d'oxyde ou de nitrure déposée doit être retirée afin de permettre la mise en oeuvre subséquente de certains procédés, par exemple de type collage.

Enfin, du fait des limitations techniques, un dépôt de diélectrique ne se fait de manière conforme que sur 1 à 4 mm, voire même parfois 3mm seulement, ce qui limite l'étendue de la protection du bevel.

Une autre façon de protéger le bevel est l'utilisation d'un ring (ou anneau) qui permet, en étant amené à proximité voire au contact du wafer, de créer une zone d'exclusion sur le bord de plaque. L'utilisation d'un tel ring nécessite l'utilisation de machines spécifiquement conçues pour cela.

Il existe donc un besoin consistant à fournir une solution pour protéger de façon satisfaisante le bevel d'un wafer lors de différentes étapes de transformation de ce même wafer et ce dans des équipements standard.

### RESUME

Pour atteindre cet objectif, selon un mode de réalisation on prévoit un procédé de transformation d'un support comprenant les étapes suivantes :
- Fournir un support présentant une face supérieure s'étendant principalement selon un plan formé par une première direction et une deuxième direction, dit plan transversal,
- Réaliser un revêtement de protection surmontant au moins partiellement une zone périphérique de la face supérieure formant un contour fermé autour d'une zone centrale de la face supérieure, la zone périphérique et la zone centrale formant ensemble l'intégralité de la face supérieure.

Le procédé se caractérise en ce que la réalisation du revêtement de protection comprend les étapes suivantes :
- Former une première couche d'une résine photosensible surmontant la face supérieure du support, la résine photosensible étant telle que :
   i. lorsque la résine est exposée à une dose d'insolation D<Dinversion, elle présente un comportement de résine positive et se dissout lorsqu'elle est mise en contact avec un développeur, et
   ii. lorsque la résine est exposée à une dose d'insolation D≥Dinversion, elle présente un comportement de résine négative et ne se dissout pas lorsqu'elle est mise en contact avec le développeur,
- Exposer une première portion de la première couche de résine photosensible avec une première dose d'insolation D1≥ Dinversion, la première portion couvrant strictement la même surface de la face supérieure que le revêtement de protection, de sorte à former le revêtement de protection,
- Exposer une deuxième portion de la première couche avec une deuxième dose d'insolation D2<Dinversion ou ne pas insoler la deuxième portion, la deuxième portion surmontant au moins une partie la zone centrale.

Le revêtement de protection constitue une couche de protection des parties sous-jacentes du support. Le reste du support, se trouvant sous la deuxième portion de la couche de résine, peut être traité sans que cela n'altère le bevel, couvert par le revêtement. On prévient ainsi toute contamination métallique ou particulaire pouvant notamment survenir lors d'étapes de gravure de la zone centrale du support.

Le revêtement de protection est formé lors d'une étape de photolithographie pouvant s'intégrer très facilement au processus global de traitement du support. La formation du revêtement de protection peut ainsi se dérouler en ligne et ne présente aucune contrainte technologique. L'invention permet donc une réduction du nombre d'étapes de fabrication et donc un gain de temps significatif lors de la confection de dispositifs microélectroniques. Par ailleurs, la couche de résine photosensible peut être déposée sur le support de façon conforme. L'étape d'insolation de la première portion de la résine n'altère aucunement la conformité du dépôt. Les dimensions de la première portion peuvent ainsi être choisies sans préjudice sur la conformité du revêtement de protection.

Un autre avantage du revêtement de protection formé par le procédé selon l'invention est qu'il peut conférer une bonne tenue mécanique au wafer lors d'une étape subséquente de découpe et individualisation de puces confectionnées à sa surface.

Le procédé selon l'invention permet en outre de réaliser un porte-plaquette (couramment désigné par le terme anglais « holder ») plus simplement que par les méthodes actuelles. La formation d'un holder selon le procédé décrit dans la présente demande est également avantageuse par rapport aux méthodes actuelles (ex. : meulage) en ce qu'elle apporte beaucoup moins de contraintes mécaniques au système.

Un deuxième aspect de l'invention concerne un dispositif microélectronique comprenant :
- un support présentant une face supérieure s'étendant principalement selon un plan formé par une première direction et une deuxième direction, dit plan transversal,
- un revêtement de protection, surmontant au moins partiellement une zone périphérique de la face supérieure formant un contour fermé autour d'une zone centrale de la face supérieure, la zone périphérique et la zone centrale formant ensemble l'intégralité de la face supérieure.

Le dispositif se caractérise en ce que le revêtement de protection est à base d'une résine photosensible négative.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A et 1B représentent la formation d'un revêtement de protection en périphérie d'un wafer selon l'art antérieur.
Les figures 2A à 2I représentent un procédé de transformation d'un support selon l'un des modes de réalisation de la présente invention. Ces figures sont toutes des vues de profil du support et des couches le surmontant. La figure 2A représente la fourniture du support.
La figure 2B illustre la formation d'une première couche de résine photosensible sur le support.
La figure 2C illustre l'insolation d'une première portion de la première couche de résine adjacente à une deuxième portion de la première couche de résine, qui elle n'est pas insolée.
La figure 2D représente l'obtention d'un revêtement de protection en périphérie du wafer suite à l'insolation de la première portion de la première couche de résine.
La figure 2E représente l'insolation de la première couche de résine au travers d'un masque de photolithographie.
La figure 2F représente la formation de motifs de photolithographie dans la deuxième portion de la première couche de résine.
La figure 2G représente le développement des motifs, permettant de révéler des zones à traiter de la face supérieure du support.
La figure 2H illustre une étape de gravure du support à partir des zones à traiter.
La figure 2I représente le retrait du revêtement de protection et des parties restantes de la deuxième portion de la première couche de résine.
La figure 2J représente l'obtention d'un revêtement de protection en périphérie du wafer suite à l'insolation de la première portion de la première couche de résine, dans le cas où le revêtement de protection ne s'étend pas jusqu'au bord du wafer.
Les figures 3A à 3M représentent un procédé de transformation d'un support selon un autre des modes de réalisation de la présente invention. Ces figures sont toutes des vues de profil du support et des couches le surmontant. La figure 3A représente la fourniture du support.
La figure 3B illustre la formation d'une première couche de résine photosensible sur le support.
La figure 3C illustre l'insolation d'une première portion de la première couche de résine adjacente à une deuxième portion de la première couche de résine, qui elle n'est pas insolée.
La figure 3D représente l'obtention d'un revêtement de protection en périphérie du wafer suite à l'insolation de la première portion de la première couche de résine. Le revêtement peut cependant être obtenu uniquement à l'étape représenté par la figure 3F.
La figure 3E illustre l'insolation de la première portion et de la deuxième portion de la première couche de résine.
Les figures 3F et 3G illustrent le développement de la deuxième portion de la première couche de résine.
La figure 3H illustre la formation d'une deuxième couche de résine sur le support.
La figure 3I représente l'insolation de la deuxième couche de résine au travers d'un masque de photolithographie.
La figure 3J représente la formation de motifs de photolithographie dans la deuxième couche de résine.
La figure 3K représente le développement des motifs dans la deuxième couche de résine, permettant de révéler des zones à traiter de la face supérieure du support.
La figure 3L illustre une étape de gravure du support à partir des zones à traiter.
La figure 3M représente le retrait du revêtement de protection et des parties restantes de la deuxième portion de la deuxième couche de résine.
La figure 3N représente le revêtement de protection lorsque celui-ci ne s'étend pas jusqu'au bord du wafer.
Les figures 4A et 4B représentent une vue de dessus des étapes illustrées par les figures 2D et 3D d'une part et 3G d'autre part.
La figure 4C est une variante de la figure 4A dans laquelle le revêtement de protection ne s'étend pas jusqu'au bord du support.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation avantageux, le support présente un premier flanc latéral et le revêtement de protection présente un deuxième flanc latéral, le premier flanc latéral et le deuxième flanc latéral étant séparés, dans le plan transversal, d'une distance radiale d103 inférieure à 0,5 cm, de préférence inférieure à 0,2cm. Cela permet d'assurer une bonne protection du bord du support. Selon un exemple avantageux, d103 est sensiblement égale à 0 cm.

Selon un mode de réalisation, le procédé comprend en outre les étapes suivantes :
- Exposer une pluralité de zones de la zone centrale du support, dites zones à traiter,
- Traiter le support à partir des zones à traiter.

Selon un exemple, les zones à traiter comprennent des zones à graver et l'étape de traitement comprend une étape de gravure du support à partir des zones à graver.

Selon un exemple, les zones à traiter comprennent des zones à implanter et l'étape de traitement comprend une étape d'implantation du support à partir des zones à implanter. Selon un mode de réalisation avantageux, l'étape d'exposition des zones à traiter comprend les étapes suivantes :
- Exposer la première couche avec une troisième dose D3 telle que 12 mJ/cm²<D3<Dinversion au travers d'un masque de photolithographie,
- Effectuer une étape de développement en mettant en contact la résine photosensible avec le développeur de sorte à faire se dissoudre les parties exposées avec D3.

Selon un mode de réalisation avantageux, le procédé comprend en outre, après l'étape d'exposition de la première portion, les étapes suivantes :
- Retirer la deuxième portion,
- Former une deuxième couche de résine photosensible surmontant le support, et l'étape d'exposition des zones à traiter comprend les étapes suivantes :
- Exposer la deuxième couche avec une troisième dose D3 telle que 12 mJ/cm²<D3<Dinversion au travers d'un masque de photolithographie,
- Effectuer une étape de développement en mettant en contact la résine photosensible avec le développeur de sorte à faire se dissoudre les parties exposées avec D3.

Selon un exemple avantageux, la première portion s'étend dans le plan transversal sur une dimension radiale I24, avec 3mm ≤ I24, de préférence 5mm ≤ I24. Selon un exemple, I24 ≤ 3 cm. Selon un autre exemple, I24 ≤ 2 cm.

Selon un exemple avantageux, la résine photosensible est composée à au moins 5% d'un dérivé de polyhydroxystyrène, au moins 55% de lactate d'éthyle et au moins 20% d'acétate d'éther méthylique de propylène glycol (PGMEA).

Selon un exemple avantageux, le support est à base d'au moins un matériau parmi les matériaux suivants : Si, SiC, GaN, SiGe, Ge, saphir, verre, InP, AsGa. Le support est avantageusement à base d'un matériau III-V, par exemple un matériau III-N. Le support peut également être un substrat du type silicium sur isolant (couramment désigné SOI, de l'anglais Silicon-On-Insulator), du type silicium sur siliciure sur isolant (couramment désigné SSOI, de l'anglais Silicon-On-Silicide-On-Insulator), ou encore du type germanium sur isolant (couramment désigné GeOI, de l'anglais Germanium-On-Insulator).

Selon un exemple avantageux, le revêtement de protection présente dans une troisième direction perpendiculaire au plan transversal une épaisseur e100 supérieure à 250 nm, de préférence supérieure à 500 nm. Typiquement, e100 ≤ 1 µm.

Selon un exemple avantageux, D1≥90mJ/cm².

Selon un exemple avantageux, dans le plan transversal, la zone centrale présente la forme d'un disque et la zone périphérique présente la forme d'une couronne circulaire.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant, soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi un matériau à base d'un matériau III-N peut comprendre un matériau III-N additionné de dopants. De même, une couche à base de GaN comprend typiquement du GaN et des alliages d'AlGaN ou d'InGaN.

Le terme « matériau III-V » fait référence à un semi-conducteur composé d'un ou plusieurs éléments de la colonne III et de la colonne V du tableau périodique de Mendeleïev. On compte parmi les éléments de la colonne III le bore, le gallium, l'aluminium ou encore l'indium. La colonne V contient par exemple l'azote, l'arsenic, l'antimoine et le phosphore. On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. La sélectivité entre A et B est notée SA:B.

Dans la présente demande de brevet, on parlera préférentiellement d'épaisseur pour une couche et de hauteur pour une structure ou un dispositif. L'épaisseur est prise selon une direction normale au plan d'extension principal de la couche, et la hauteur est prise perpendiculairement au plan de base XY. Ainsi, une couche présente typiquement une épaisseur selon z, lorsqu'elle s'étend principalement le long d'un plan XY, et un élément en saillie, par exemple une tranchée d'isolation, présente une hauteur selon z. Les termes relatifs « sur », « sous », « sous-jacent » se réfèrent préférentiellement à des positions prises selon la direction z.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Dans le cadre de la présente invention, on qualifie de résine un matériau organique ou organo-minéral pouvant être mis en forme par une exposition à un faisceau d'électrons, de photons, de rayons X, un faisceau de lumière dans la gamme des ultraviolets, des extrêmes ultraviolets (UEV) ou des ultraviolets profonds (Deep UV) typiquement dans la gamme de longueurs d'onde de 193 nm à 248 nm, les raies d'émissions d'une lampe mercure, soit : 365 nm pour la I line, 435 nm pour la G line et 404 nm pour la H line. L'invention s'applique également aux résines qui peuvent être mises en forme mécaniquement, notamment par impression assistée thermiquement ou par ultraviolets.

Dans le cadre de la présente invention, les résines utilisées sont des résines à tonalité positive habituellement utilisées en lithographie. Ces résines à tonalité positive peuvent voir leur tonalité s'inverser, pour présenter un comportement de résine à tonalité négative lorsqu'elles reçoivent une dose supérieure à une dose Dinversion.

On dit qu'une résine positive voit sa tonalité s'inverser pour devenir une résine négative si, après avoir exposé une zone de la résine positive en lui appliquant une dose D≥Dinversion le motif défini par la zone exposée ne se dissout pas lorsqu'il est mis en contact avec un développeur qui fait se dissoudre la même résine lorsqu'elle présente son comportement initial de résine positive. Cette zone exposée reste donc en place à l'issue d'une étape de développement classique, étape de développement qui permettrait de faire disparaître les zones de cette résine exposées à une dose inférieure à une dose d'activation Dactivation. Par ailleurs, tant qu'elle n'est pas exposée à une dose supérieure à Dactivation, la résine est également sensible à un nouveau couchage de résine, et plus particulièrement au solvant de cette résine.

Il est entendu qu'une étape de développement peut comprendre un ou plusieurs mises en contact de la résine avec un développeur, dites sous-étapes de développement. Les différentes sous-étapes de développement peuvent être mises en oeuvre à l'aide d'une même solution développante ou plusieurs solutions développante. Il est également possible de faire suivre l'étape de développement d'une étape de nettoyage permettant de retirer des résidus de résine. Pour savoir si une résine présente cette capacité à voir sa tonalité s'inverser plusieurs méthodes existent. On peut par exemple réaliser pour cette résine une courbe de contraste (habituellement désignée par le vocable anglais « contrast curve »), bien connue de l'homme du métier. Pour réaliser cette courbe, on peut mesurer l'épaisseur de la résine restante après développement en fonction de la dose d'exposition appliquée à la résine, cette dose d'exposition étant choisie dans une plage bien supérieure à la plage habituellement utilisée pour cette résine.

La courbe de contraste présente alors sur l'axe des abscisses les doses appliquées et sur l'axe des ordonnées les épaisseurs mesurées de résine après chaque cycle d'exposition et de développement. Typiquement, pour une valeur en abscisses comprises entre zéro et Dactivation, la courbe correspond à une épaisseur de la résine qui reste constante et qui est sensiblement égale à l'épaisseur initiale de la résine. Pour une dose D supérieure ou égale à Dactivation, l'épaisseur devient nulle car la résine est développée. Puis, si une augmentation en abscisse de la dose d'exposition provoque une augmentation de l'épaisseur de résine, cela signifie que cette résine présente ce comportement d'inversion. Cette augmentation de l'épaisseur permet également d'identifier le seuil d'exposition Dinversion au-delà duquel cette inversion s'effectue. De préférence, au-delà de ce seuil Dinversion l'épaisseur de la résine reste constante et est proche de son épaisseur initiale. On peut citer à titre d'exemple des résines classiquement employées en microélectronique, des résines à base de méthacrylate (par exemple le Polymethyl méthacrylate PMMA), de polyhydroxystyrène (PHS) et les résines basées sur des principes de photo-décomposition telles que des résines azide quinone, i.e, diazonaphthaquinone (DQ). Il est par exemple possible d'employer une résine appartenant à la série M commercialisée par JSR Life Sciences, par exemple les résines M78Y et M79Y.

Dans la présente description, on qualifie de dose une quantité d'énergie reçue par une résine par unité de surface. Cette énergie peut être sous forme de photons (photolithographie) pour une résine photosensible. La dose est alors habituellemepnt exprimée en Joules par m², ou plus souvent en milli Joules (mJ) par cm⁻² (10⁻² m²) soit en mJ/m².

Cette énergie peut également être sous forme d'électrons (lithographie électronique) pour une résine électrosensible. La dose est alors habituellement exprimée en Coulombs par m2, ou plus souvent en micro Coulombs (µC) par cm⁻² (10⁻² m²) soit en µC/m².

On entend par « nature » d'un matériau tel qu'une résine sa composition chimique, c'est-à-dire la nature et la proportion des espèces constituant le matériau. Deux couches sont considérées comme faites d'une même résine si elles présentent la même composition chimique.

Une même résine peut présenter des zones dont les comportements diffèrent vis-à-vis des solutions de développement. La différenciation de ces zones est obtenue par la dose d'énergie appliquée lors d'une exposition à chacune de ces zones. Ainsi, ces zones diffèrent par leur masse molaire. On peut par exemple mesurer ces masses molaires par chromatographie ou par spectrométrie de masse.

Ainsi deux portions ou zones d'une même résine peuvent être de même composition chimique mais présenter des tonalités différentes.

Les étapes du procédé telles que revendiquées s'entendent au sens large et peuvent éventuellement être réalisées en plusieurs sous-étapes.

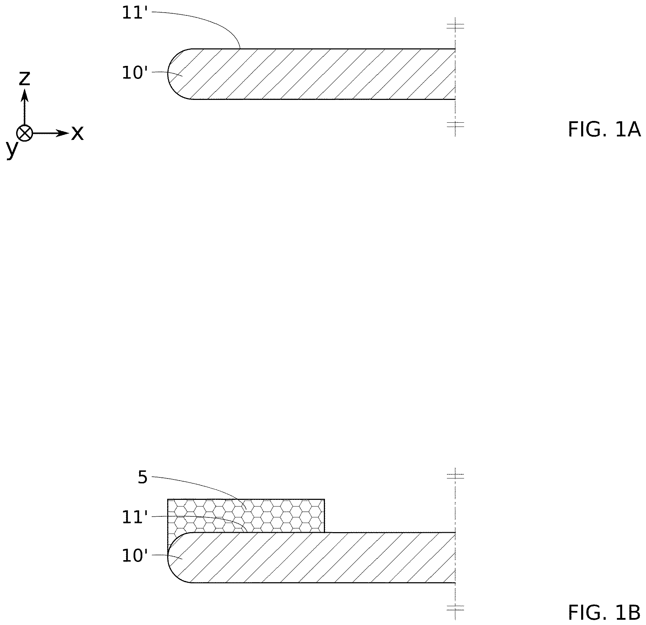

Un repère, de préférence orthonormé, comprenant les axes x, y, z est représenté en figures 1A, 2A, 3A et 4A. Ce repère est applicable par extension aux autres figures.

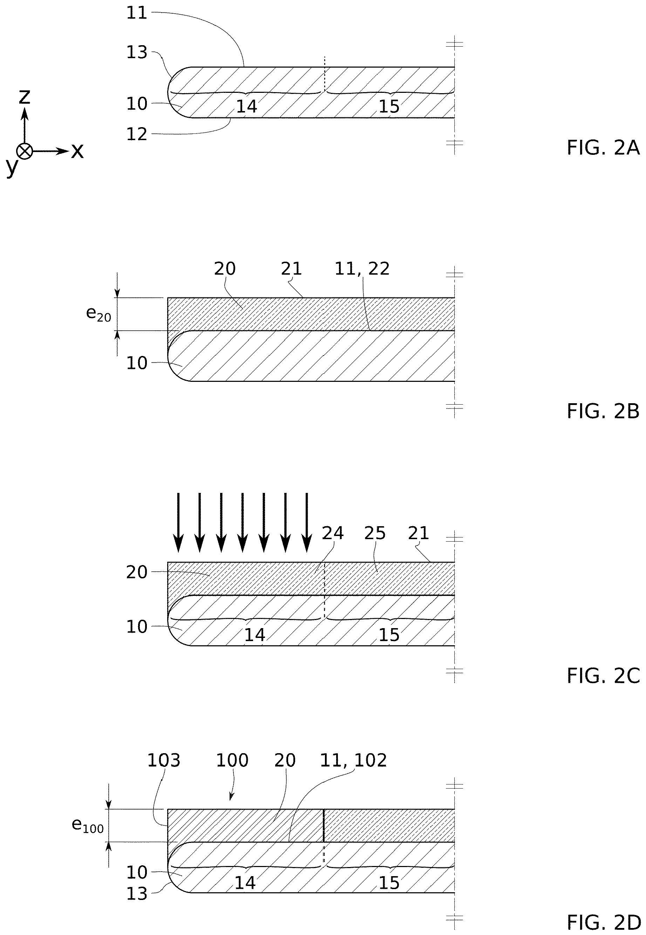

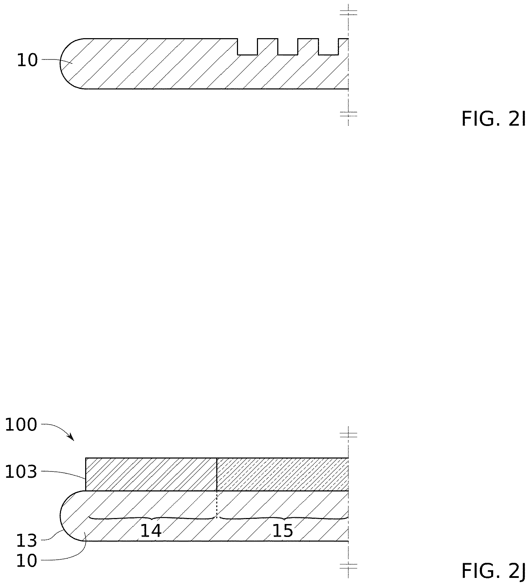

Plusieurs exemples de modes de réalisation du procédé de transformation d'un support 10 vont maintenant être décrits en référence aux figures 2A à 3M.

La figure 2A illustre la fourniture du support 10. Ce support est typiquement une plaquette, couramment désignée par le terme anglais de « wafer ». Il s'agit classiquement d'un wafer de silicium. Il peut également s'agir d'un substrat de SiC ou GaN ou encore d'un empilement SOI (« Silicon-On Insulator », silicium sur isolant) ou GeOI (« Germanium-On-Insulator », germanium sur isolant).

Le support 10 présente une face supérieure 11 et une face inférieure 12 s'étendant toutes les deux principalement dans le plan XY du repère orthogonal XYZ. Il présente également un flanc latéral 103, dit premier flanc latéral 103, joignant la face supérieure 11 et la face supérieure 12.

De façon tout à fait classique, le support 10 et donc sa face supérieure 11 présentent dans le plan XY la forme d'un disque. La face supérieure 11 du support 10 est constituée de deux zones :
- une zone centrale 15 ayant de préférence également la forme d'un disque dans le plan XY,
- une zone périphérique 14 ayant avantageusement la forme d'une couronne circulaire dans le plan XY.

La zone périphérique 14 forme un contour fermé autour de la zone centrale 15. La zone centrale 15, la zone périphérique 14 et la face supérieure 11 sont de préférence concentriques dans le plan XY.

Comme illustré à la figure 2B, une première couche 20 d'une résine photosensible est ensuite formée sur la face supérieure 11 du support 10. Elle présente elle aussi une face supérieure 21 et une face inférieure 22 s'étendant toutes les deux principalement dans le plan XY.

La résine photosensible présente la caractéristique, comme décrit largement plus haut, d'avoir :
- Un comportement de résine positive tant qu'elle n'a pas été exposée à une dose supérieure à la dose Dinversion. La résine se dissout alors lorsqu'elle est mise en contact avec un développeur.
- Un comportement de résine négative lorsqu'elle est exposée à une dose supérieure à la dose Dinversion.

Une première portion 24 de la première couche 20 est exposée à une dose d'insolation D1 supérieure ou égale à Dinversion. La première portion 24 se situe à l'aplomb d'une partie au moins de la zone périphérique 14. Une deuxième portion 25 de la première couche 20 est elle exposée à une dose d'insolation strictement inférieure à Dinversion, voire n'est pas insolée du tout. La deuxième portion 25 recouvre au moins une partie de la zone centrale 15 de la face supérieure 11 du substrat 10.

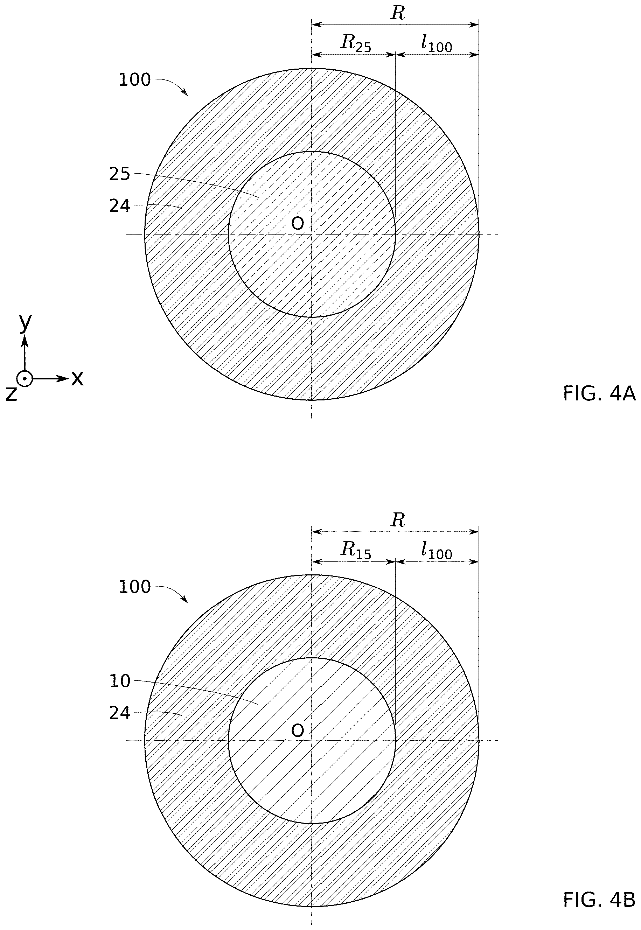

Une fois insolée à une dose supérieure à Dinversion, la première portion 24 est donc résistante à une mise en contact avec un développeur. On obtient ainsi un revêtement de protection 100 constitué de la résine à tonalité négative, ce qui correspond à la première portion 24. Cela est illustré par les figures 2D et 4A, constituant respectivement une vue de profil et une vue de dessus de l'empilement.

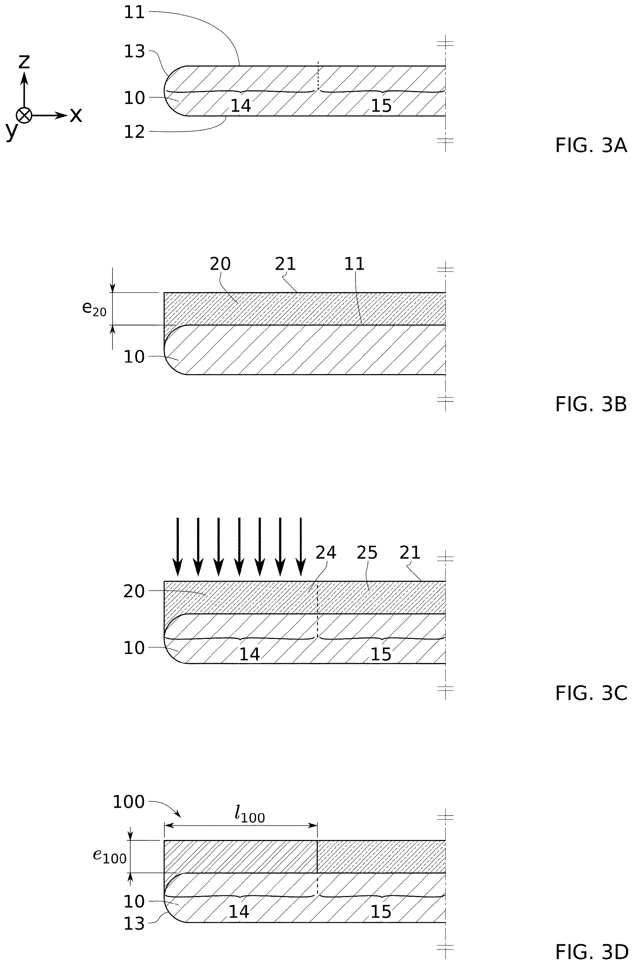

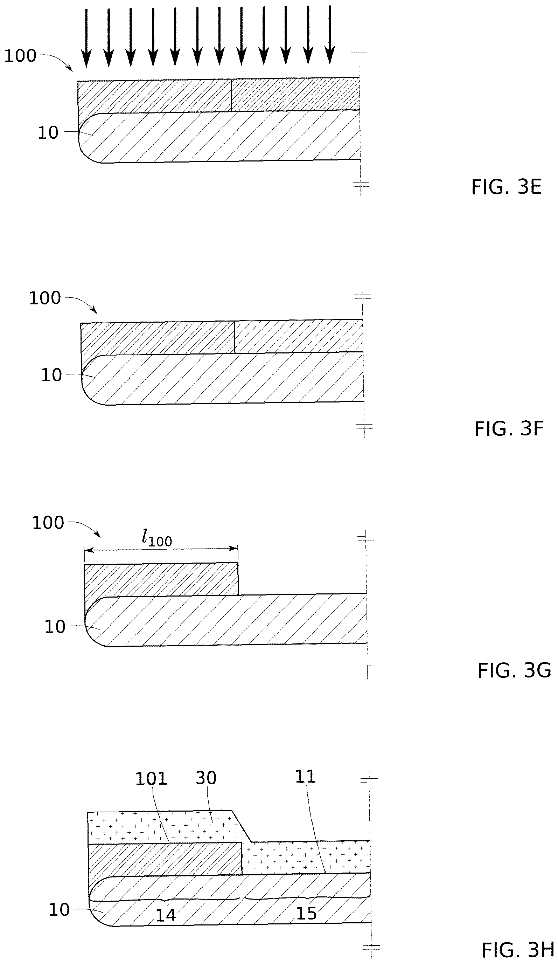

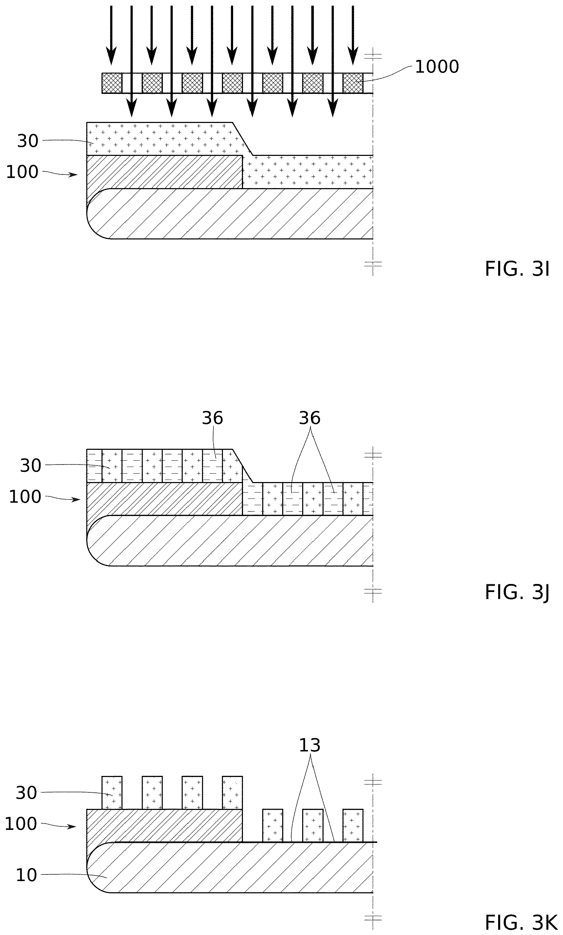

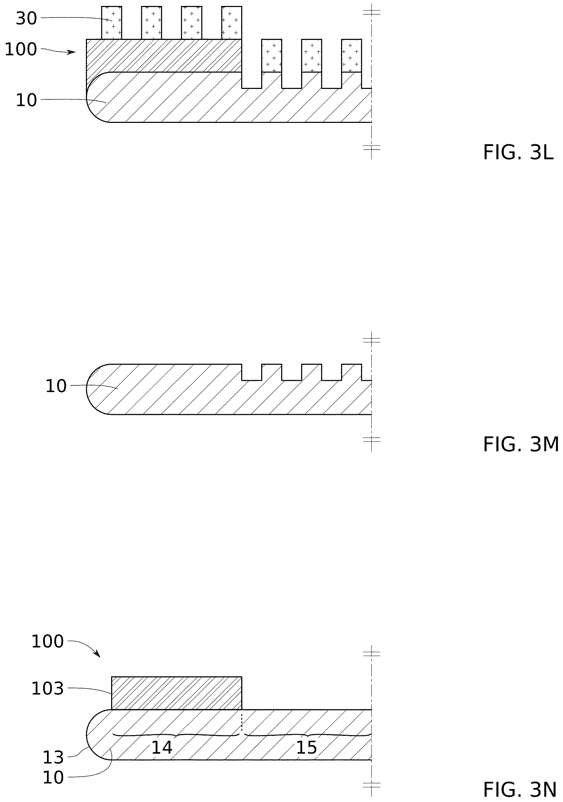

Un autre mode de réalisation du revêtement de protection 100 va maintenant être décrit en référence aux figures 3A à 3G.

Les figures 3A et 3B illustrent des étapes similaires à celles illustrées par les figures 2A et 2B, respectivement.

Dans ce mode de réalisation, le revêtement de protection 100 est obtenu, de façon similaire au précédent mode de réalisation, par exposition de la première portion 24 à une dose d'insolation supérieure à la dose d'inversion Dinversion. Il est cependant cette fois prévu que la première portion 24 subisse deux étapes d'insolation, illustrées aux figures 3C à 3F :
- Une première insolation à une dose D1' de la première portion 24 uniquement,
- Une deuxième insolation à une dose D1" de la première portion 24 et de la deuxième portion 25.

La dose totale reçue par la première portion 24 permet de la rendre négative : D1'+D1" ≥ Dinversion. Il est envisageable que la première insolation suffise à inverser le comportement de la résine constituant la première portion 24, c'est-à-dire que D1' ≥ Dinversion. Il est également tout à fait possible de prévoir que l'inversion de comportement se déroule lors de la deuxième insolation, c'est-à-dire que D1' < Dinversion mais D1'+D1" ≥ Dinversion. Dans tous les cas, on a D1" < Dinversion : la deuxième portion conserve un comportement de résine positive suite à la deuxième insolation.

La deuxième insolation peut également simultanément constituer une étape de photolithographie classique : la dose D1" peut être calibrée de sorte à permettre un développement de la deuxième portion 25. Cette dernière peut en effet, suite à son exposition à la dose D1", être développée à l'aide d'un développeur et ainsi être retirée par dissolution, comme l'illustre le passage de la figure 3F à la figure 3G. Cette étape est également illustrée par le passage de la figure 4A à la figure 4B, pendants en vue de dessus des figures 3F et 3G.

Le revêtement de protection 100 est lui obtenu soit lors de la première insolation (passage de la figure 3C à la figure 3D), soit lors de la deuxième insolation. Il ne subit aucun dommage lors du développement de la deuxième portion 25.

Suite à l'obtention du revêtement de protection 100 par l'un des modes de réalisation décrits ci-dessus, le procédé peut se poursuivre avec des étapes de traitement de la zone centrale 15. Plus particulièrement, on peut chercher à ne traiter que certaines parties de la zone centrale 15, dites zones à traiter 13. Selon le cadre dans lequel le procédé selon l'invention est mis en oeuvre, le traitement en question peut être une gravure - humide ou sèche -, une implantation, une étape de découpe ou singularisation...

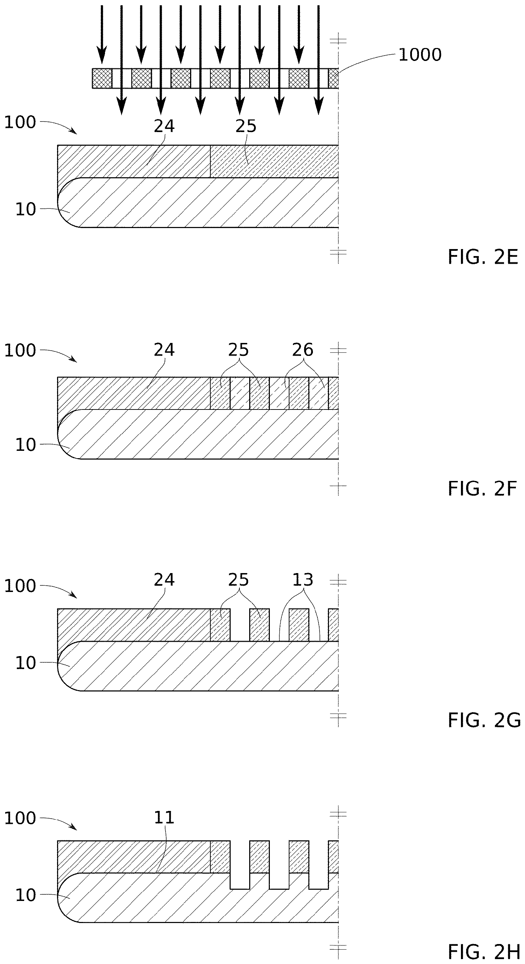

Il est ainsi possible, à la suite du premier mode de réalisation du revêtement de protection 100 décrit plus haut, d'exposer la première couche 20 à une dose d'insolation au travers d'un masque de photolithographie 1000 (figure 2E). Le comportement du revêtement de protection 100 restera inchangé après cette insolation, tandis que les motifs exposés 26 de la deuxième portion 25 pourront être développés en les mettant en contact avec un développeur (figures 2F et 2G).

Les parties de la face supérieure 11 du support 10 mises à jour lors du retrait des motifs 26 correspondent aux zones à traiter 13.

Les zones à traiter 13 peuvent ensuite être traitées sans que cela n'altère le bevel, protégé par le revêtement de protection 100. Ce traitement peut comprendre une ou plusieurs étapes. Parmi les étapes de traitement possible, on cite par exemple une gravure - humide ou sèche -, une implantation, une étape de découpe ou singularisation... La figure 2H illustre par exemple une étape de gravure du support 10 à partir des zones à traiter 13. Comme illustré, grâce à la présence du revêtement de protection 100, la zone périphérique 14, ou du moins la partie de la zone périphérique 14 sous-jacente à la première portion 24, comprenant le bevel, ne subit aucun dommage dû à la gravure (ou toute autre étape de traitement).

Comme illustré à la figure 2I, les parties restantes de la première couche 20 ainsi que le revêtement de protection 100 peuvent être retirés lors d'une étape subséquente aux étapes de traitement du support. On obtient alors un support présentant un bevel intact, non contaminé et avec un excellent état de surface. Ce retrait peut par exemple être effectué par décapage, par exemple plasma (en anglais « stripping plasma »), et gravure humide. Après ce retrait, on peut par exemple procéder à un collage du support avec un autre élément. La qualité de ce collage est améliorée par rapport à l'art antérieur du fait du bon état de propreté et de l'excellente intégrité du bevel.

Dans ce premier mode de réalisation, la première couche 20 a donc un rôle double : elle permet à la fois, au niveau de sa première portion 24 qui est transformée en revêtement de protection 100, de protéger le bevel, et de réaliser une étape classique de photolithographie au niveau de sa deuxième portion 25. La protection du bevel et le traitement de la zone centrale 15 du support sont donc tous deux permis par un unique dépôt de résine. Le procédé selon ce mode de réalisation s'en retrouve particulièrement simple et permet une réduction du nombre d'étapes de procédé - et donc un gain de temps - conséquent.

Un autre mode de réalisation de la suite du procédé de traitement du support 10 suite à l'obtention du revêtement de protection 100 selon les étapes illustrées par les figures 3A à 3G va maintenant être décrit en référence aux figures 3H à 3M.

Comme représenté à la figure 3H, une deuxième couche 30 de résine photosensible est déposée sur le support 10. Plus exactement, la deuxième couche 30 recouvre directement la zone centrale 15 de la face supérieure 11 du support et la face supérieure 101 du revêtement de protection 100. Cette dernière correspond à la partie de la face supérieure 21 de la première couche 20 s'étendant au-dessus de la première portion 24. Un tel dépôt pleine plaque présente l'avantage d'être très facilement réalisable techniquement. Le fait que la deuxième couche 30 s'étende sur le revêtement de protection est sans incidence sur la suite du procédé.

La résine photosensible de la deuxième couche 30 peut être la même que celle employée pour la première couche 20. Cela présente un avantage sur le comportement à l'interface entre la première couche 20 et la deuxième couche 30. Il peut cependant également s'agir d'une autre résine photosensible. Il n'est notamment pas nécessaire que la résine de la deuxième couche 30 soit inversible.

La deuxième couche 20 peut ensuite être exposée à une dose d'insolation au travers d'un masque de photolithographie 1000 (figure 3I). Les motifs exposés 36 de la deuxième couche 30 pourront être développés à l'aide d'un développeur.

Comme dans le mode de réalisation décrit précédemment, ce retrait permet de mettre à jour certaines parties de la face supérieure 11 du support 10 correspondent aux zones à traiter 13.

Comme précédemment, les zones à traiter 13 peuvent ensuite être traitées (gravure, implantation...) sans que cela n'altère le bevel, protégé par le revêtement de protection 100. La figure 3L illustre par exemple une étape de gravure du support 10 à partir des zones à traiter 13. Le bevel, se trouvant sous le revêtement de protection 100, ne subit aucun dommage dû à la gravure (ou toute autre étape de traitement).

La figure 3M illustre une étape facultative de retrait des parties restantes de la deuxième couche 30 ainsi que le revêtement de protection 100. On obtient alors un support présentant un bevel intact, non contaminé et avec un excellent état de surface.

Quel que soit le mode de réalisation du procédé, les dimensions du revêtement de protection sont choisies de sorte à protéger le bevel.

Le revêtement de protection 100 présente dans le plan transversal XY une dimension radiale I100 mesurée à partir du centre O du wafer. De la même façon, on définit une dimension radiale I14 de la zone périphérique 14, une dimension radiale I24 de la première portion 24, un rayon R15 de la zone centrale et un rayon R25 de la deuxième portion. Par construction, le revêtement de protection étant formé par insolation de la première portion 24, on a I100=I24.

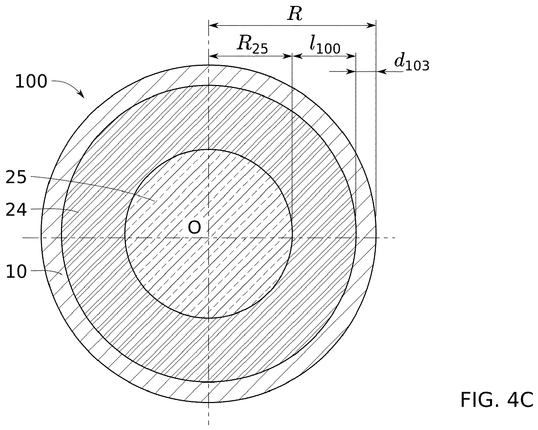

La distance du revêtement de protection 100 à l'extrême périphérie du support 10 est caractérisée par la distance radiale d103 dans le plan XY entre le flanc 13 du support, dit premier flanc latéral 13, et le flanc 103 du revêtement 100 (voir figure 4C). Comme représenté sur les figures, le flanc 13 du support peut être incurvé. On assimile alors la position dans le plan XY de ce premier flanc latéral 13 à la position de la jointure entre le flanc 13 et la face supérieure 11 du support.

Avantageusement, la distance d103 est inférieure ou égale à 0,5 cm, de préférence inférieure ou égale à 0,2 cm. De préférence, la face inférieure 102 du revêtement de protection 100 s'étend depuis la périphérie du support 10 afin d'obtenir la meilleure protection pour le bevel : la distance d103 est alors sensiblement nulle, comme illustré aux figures 2D, 3G et 4A.

Avantageusement, le revêtement de protection 100 recouvre toute la zone périphérique 14 et on a ainsi I100=I24=I14.

Pour un wafer de rayon R, 1100 est avantageusement compris entre 1% et 20% de R, de préférence entre 5% et 15%, de préférence entre 5% et 10%. Pour un wafer de 300 millimètres de diamètre, I100 est de préférence compris entre 0,5 à 3 cm.

Lors de sa formation, le revêtement de protection 100 présente en outre selon la direction une épaisseur e100. Cette épaisseur est choisie en fonction du niveau de dégradation que le revêtement 100 va subir lors des étapes subséquentes de traitement de la zone centrale 15. Le revêtement 100 doit en effet être suffisamment épais pour protéger le bevel jusqu'à la fin de ces étapes. Par exemple, si ces étapes comprennent une ou plusieurs étapes de gravure du support, le choix de l'épaisseur e100 se fait entre autres en fonction de la sélectivité de la gravure entre le matériau du support et la résine photosensible. Typiquement, e100 est supérieure ou égale à 250 nm, de préférence supérieure ou égale à 500 nm.

L'invention n'est pas limitée aux modes de réalisations précédemment décrits et s'étend à tous les modes de réalisation couverts par l'invention.

## Revendications

1. Procédé de transformation d'un support comprenant les étapes suivantes :
• Fournir un support (10) présentant une face supérieure (11) s'étendant principalement selon un plan formé par une première direction (X) et une deuxième direction (Y), dit plan transversal (XY),
• Réaliser un revêtement de protection (100) surmontant au moins partiellement une zone périphérique (14) de la face supérieure (11) formant un contour fermé autour d'une zone centrale (15) de la face supérieure (11), la zone périphérique (14) et la zone centrale (15) formant ensemble l'intégralité de la face supérieure (11),
la réalisation du revêtement de protection (100) comprenant les étapes suivantes :
• Former une première couche (20) d'une résine photosensible surmontant la face supérieure (11) du support (10), la résine photosensible étant telle que :
i. lorsque la résine est exposée à une dose d'insolation D<Dinversion, elle présente un comportement de résine positive et se dissout lorsqu'elle est mise en contact avec un développeur, et
ii. lorsque la résine est exposée à une dose d'insolation D≥Dinversion, elle présente un comportement de résine négative et ne se dissout pas lorsqu'elle est mise en contact avec le développeur,
• Exposer une première portion (24) de la première couche (20) de résine photosensible avec une première dose d'insolation D1≥ Dinversion, la première portion (24) couvrant strictement la même surface de la face supérieure (11) que le revêtement de protection (100), de sorte à former le revêtement de protection (100),
• Exposer une deuxième portion (25) de la première couche (20) avec une deuxième dose d'insolation D2<Dinversion ou ne pas insoler la deuxième portion (25), la deuxième portion (25) surmontant au moins une partie la zone centrale (15),
le procédé étant **caractérisé en ce qu'**il comprend en outre les étapes suivantes :
• Exposer une pluralité de zones de la zone centrale (15) du support (10), dites zones à traiter (13),
• Traiter le support (10) à partir des zones à traiter (13), l'étape d'exposition des zones à traiter (13) comprenant les étapes suivantes :
• Exposer la première couche (20) avec une troisième dose D3 telle que 12 mJ/cm²<D3<Dinversion au travers d'un masque de photolithographie (1000),
• Effectuer une étape de développement en mettant en contact la résine photosensible avec le développeur de sorte à faire se dissoudre les parties exposées avec D3.

2. Procédé selon la revendication précédente, dans lequel le support (10) présente un premier flanc latéral (13) et le revêtement de protection (100) présente un deuxième flanc latéral (103), le premier flanc latéral (13) et le deuxième flanc latéral (103) étant séparés, dans le plan transversal (XY), d'une distance radiale d103 inférieure ou égale à 0,5 cm, de préférence inférieure ou égale à 0,2 cm.

3. Procédé selon la revendication précédente, dans lequel d103 est sensiblement égale à 0 cm.

4. Procédé selon l'une quelconque des revendications précédentes, dans lequel les zones à traiter (13) comprennent des zones à graver (13) et dans lequel l'étape de traitement comprend une étape de gravure du support (10) à partir des zones à graver (13).

5. Procédé selon l'une quelconque des revendications précédentes, dans lequel les zones à traiter (13) comprennent des zones à implanter (13) et dans lequel l'étape de traitement comprend une étape d'implantation du support (10) à partir des zones à implanter (13).

6. Procédé selon l'une quelconque des revendications précédentes dans lequel la première portion (24) s'étend dans le plan transversal (XY) sur une dimension radiale I24, avec 3mm ≤ I24, de préférence 5mm ≤ I24.

7. Procédé selon l'une quelconque des revendications précédentes dans lequel la résine photosensible est composée à au moins 5% d'un dérivé de polyhydroxystyrène, au moins 55% de lactate d'éthyle et au moins 20% d'acétate d'éther méthylique de propylène glycol (PGMEA).

8. Procédé selon l'une quelconque des revendications précédentes dans lequel le support (10) est à base d'au moins un matériau parmi les matériaux suivants : Si, SiC, GaN, SiGe, Ge, saphir, verre, InP etAsGa.

9. Procédé selon l'une quelconque des revendications précédentes dans lequel le revêtement de protection (100) présente dans une troisième direction (Z) perpendiculaire au plan transversal (XY) une épaisseur e100 supérieure à 250 nm, de préférence supérieure à 500 nm.

10. Procédé selon l'une quelconque des revendications précédentes dans lequel D1≥90mJ/cm².

11. Procédé selon l'une quelconque des revendications précédentes dans lequel, dans le plan transversal (XY), la zone centrale présente la forme d'un disque et la zone périphérique présente la forme d'une couronne circulaire.
